# EUROPEAN PATENT APPLICATION

(11) **EP 1 871 062 A1**
(43) Date of publication of application: **26.12.2007**
(21) Application number: 05728518.1
(22) Date of filing: 08.04.2005
(51) Int. Cl.: H04L 27/06, G06K 17/00

(54) **WIRELESS DEVICE USING SAME CARRIER WAVE FOR TRANSMISSION AND RECEPTION**

(71) Applicant: Fujitsu Frontech Limited, Inagi-shi, Tokyo 206-8555 (JP); Fujitsu Ltd., Kawasaki-shi, Kanagawa 211-8588 (JP)
(72) Inventor: KAWASAKI, Yusuke, Fujitsu Frontech Limited, Inagi-shi, Tokyo 206-8555 (JP); NINOMIYA, Teruhisa, Fujitsu Limited, Kawasaki-shi, Kanagawa 211-8588 (JP)
(74) Representative: Fenlon, Christine Lesley
(86) International application number: PCT/JP2005/006930
(87) International publication number: WO 2006/114845

(57) **Abstract**

A wireless apparatus using the same carrier wave for transmission and reception is configured to store/hold, in a sample-hold circuit SH, a DC component generated by an interference wave, such as a carrier leakage, overlapped on a baseband signal demodulated by a demodulator DEM within a reception circuit of the apparatus, to remove the DC component, and to amplify a desired baseband signal at a high gain in a differential amplification circuit at the next stage.

## Description

### Technical Field

The present invention relates to a wireless apparatus using the same carrier wave for transmission and reception, and in particular to a wireless apparatus, such as an RFID tag reader/writer, using the same carrier frequency for transmission and reception.

### Background Art

In recent years, there has been increasing attention on automatic recognition techniques of a Radio Frequency Identification (RFID) tag using an RFID tag reader/writer for use in commercial product identification and the prevention of theft in physical distribution systems and for use in entrance/exit management systems to eliminate trespassing.

The RFID tag reader/writer and RFID tag using radio waves performs a reception (i.e., a demodulation) by using the same carrier signal as the one used at the time of transmission, that is, having the same carrier frequency for transmission and reception. The use of the same carrier signal of the same frequency for transmission and reception causes the output signal of a demodulation to include a direct current (DC) component; this inclusion of the DC component results from the leakage of a transmission carrier signal within an apparatus (such as a directional coupler and the layout of circuit components for a board) and from re-reception of the signal due to the reflection of radio waves emitted from an antenna only once, resulting in a DC offset.

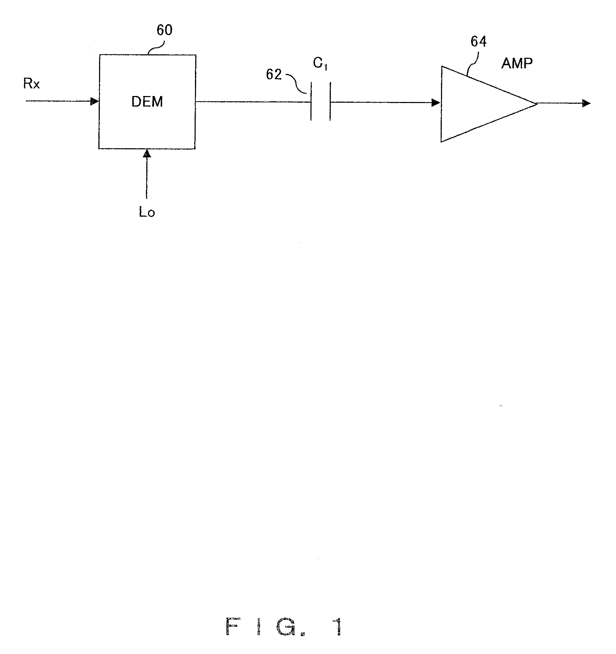

Fig. 1 is a diagram showing the principle of a reception circuit for a conventional wireless apparatus using the same carrier frequency for transmission and reception. Referring to Fig. 1, the reception circuit for a conventional wireless apparatus (such as an RFID tag reader/writer) that uses the same carrier frequency for transmission and reception is configured with a capacitor 62 placed between a demodulator 60 and an amplifier 64 to remove the DC component from a demodulator output signal by using the capacitor 62. The technique for removing the DC component from an output signal by placing a capacitor in such a way is well known to persons skilled in the art, as shown in a reference patent document 1.

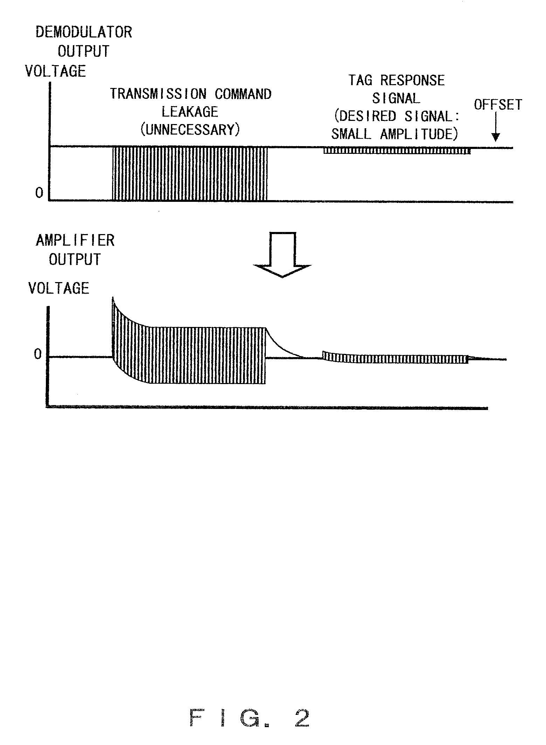

Fig. 2 is a diagram showing an outline of a waveform of the conventional reception circuit shown in Fig. 1 and an outline of the process. When removing a DC component with a capacitor as shown in Fig. 2, a DC offset is overlapped with a demodulator output, and therefore the intervention of a capacitor inevitably causes the demodulator output signal to be differentiated, thus bringing forth the problem of deforming the waveform and making it very difficult to sharply extract an original signal.

In the conventional configuration shown in Fig. 1, a decrease in the capacitance of the capacitor 62 to speed up the reaction to a variation in the DC component, for example, removes a necessary signal component within a reception signal, resulting in the deformation of the signal waveform. In contrast, an increase in the capacitance of the capacitor 62 to avoid the aforementioned problem delays the reaction to a variation of the DC component. This is a critical problem when a single RFID tag reader/writer is used so as to be supportive of a plurality of protocols with different transmission/reception transfer rates for RFID tags.

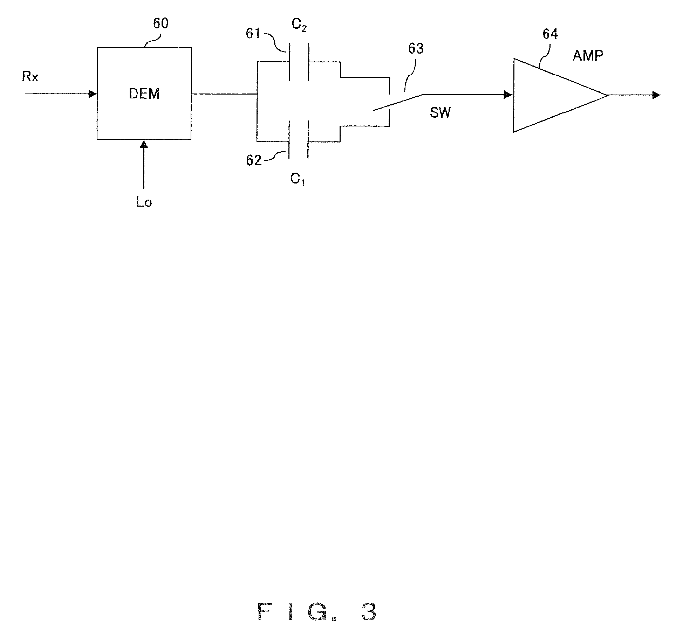

Fig. 3 is a diagram showing the principle of another reception circuit for a conventional wireless apparatus using the same carrier frequency for transmission and reception. The comprisal shown in Fig. 3 is configured so as to place a plurality of capacitors 61 and 62 in a reception circuit of an RFID tag reader/writer and to change over between the plurality of capacitors 61 and 62 by using a switch 63 as needed, thereby responding to a plurality of protocols with different transmission/reception transfer rates for RFID tags. Changing over between capacitors to respond to a plurality of protocols with different transmission/reception transfer rates, however, is too cumbersome to endure actual usage in responding to the problem of the intervention of a coupling capacitor deforming a waveform.

Trying to solve the above described problem by eliminating the coupling capacitor is faced with the problem that the degree of amplification of an amplifier cannot be made large (e.g., up to a few times at most) because a DC offset has a large signal level compared to the alternate current (AC) component that is the original signal component when an RFID tag reader/writer deals with a minute signal from a passive type tag (i.e., a tag having no power source) existing at a large distance from the antenna.

Patent document 1: Laid-Open Japanese Patent Application Publication No. H09-331298

### Disclosure of Invention

A DC component constituting a problem in the above described conventional configuration has the characteristic of the variation of the DC component being extremely small during an exchange (of communication) with an RFID tag, while the DC component largely depends on transmission carrier leakage within an RFID tag reader/writer and an environment thereof surrounding the RFID tag.

Focusing attention on this characteristic, the present invention aims to solve the problem described above. That is, the present invention is a wireless apparatus using the same carrier wave for transmission and reception; this wireless apparatus is configured to store/hold in a sample-hold circuit, a DC component generated by an interference wave, such as carrier leakage, that is overlapped on a baseband signal demodulated by a demodulator within a reception circuit of the apparatus, then to remove the DC component and amplify a desired baseband signal at a high gain in a differential amplification circuit at the next stage.

The present invention is contrived to make it possible to remove an unnecessary DC component followed by amplification of the signal, thereby acquiring the benefit of increasing the degree of amplification of an amplifier to two to three digits. In addition, the complete removal of DC components included in a received baseband signal is enabled, thereby acquiring the benefit of reproducing an amplitude-modulated desired signal component securely in a passive type tag that is performing a transmission using the carrier signal that was used at the time of the transmission. Moreover, the present invention is contrived to enable the extraction of an amplitude-modulated desired signal component independent of the transmission/reception transfer rate of an RFID tag.

### Brief Description of Drawings

[Fig. 1] A diagram showing the principle of a reception circuit for a conventional wireless apparatus using the same carrier frequency for transmission and reception;
[Fig. 2] A diagram showing an outline of a waveform of the conventional reception circuit shown in Fig. 1 and that of the process;
[Fig. 3] A diagram showing the principle of another reception circuit for a conventional wireless apparatus using the same carrier frequency for transmission and reception;
[Fig. 4] A diagram showing the principle of a reception circuit for a wireless apparatus according to a preferred embodiment of the present invention using the same carrier frequency for transmission and reception;
[Fig. 5] A block diagram showing an outline configuration of a wireless apparatus according to a preferred embodiment of the present invention using the same carrier frequency for transmission and reception;
[Fig. 6] A diagram showing an outline of a waveform of the reception circuit shown in Fig. 4 and that of the process; and
[Fig. 7] A waveform diagram of a different sample point to that in the waveform diagram of the upper part of Fig. 6.

### Best Mode for Carrying Out the Invention

The following is a description of the preferred embodiment of the present invention, referring to the accompanying drawings.

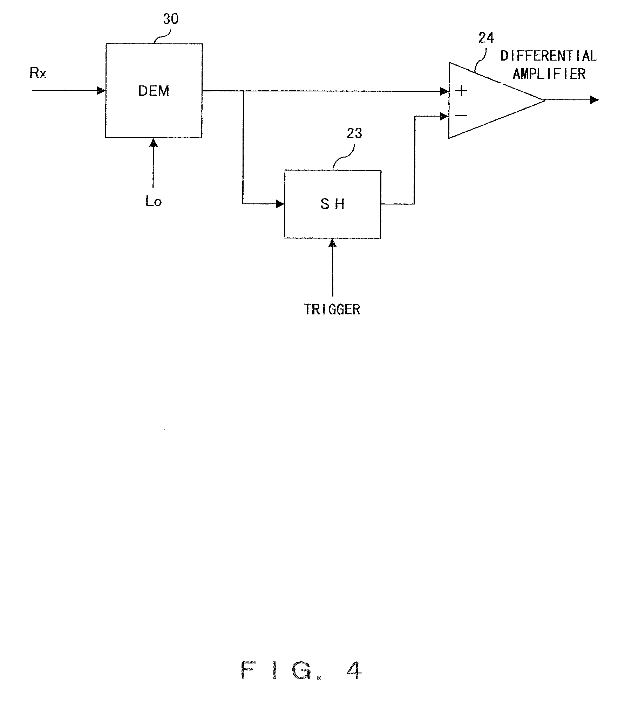

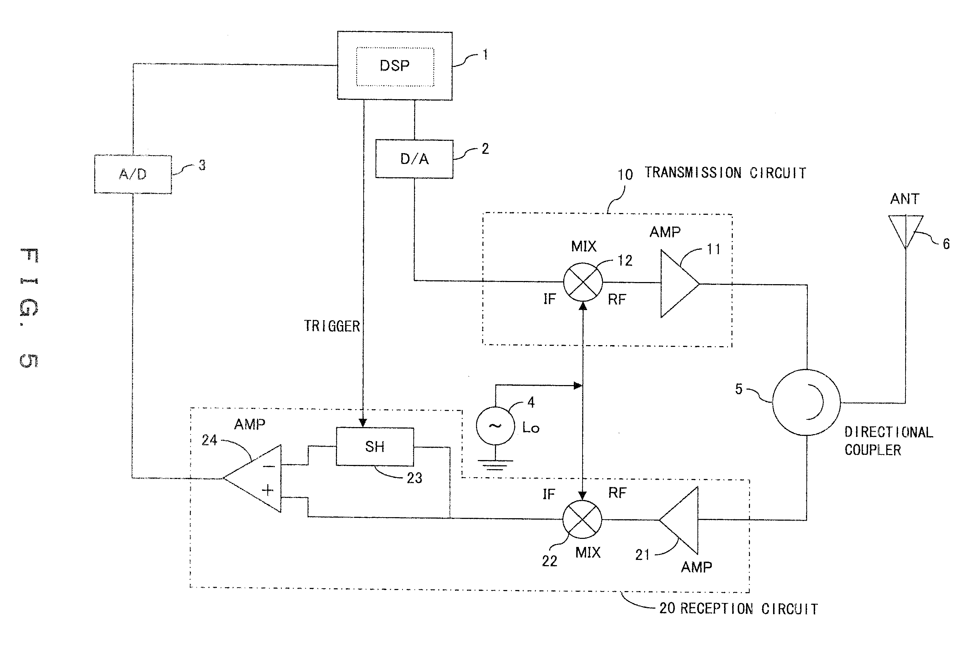

Fig. 4 is a diagram showing the principle of a reception circuit for a wireless apparatus according to a preferred embodiment of the present invention using the same carrier frequency for transmission and reception. The wireless apparatus according to a preferred embodiment of the present invention, using the same carrier frequency for transmission and reception (being applied to an RFID tag reader/writer, for example), has a reception circuit that comprises a demodulator DEM30 for demodulating an RF reception signal (RX) that is based on a local (Lo) signal and that enters from an antenna (refer to Fig. 5); a sample-hold circuit SH23 for carrying out sampling via the triggering of a Digital Signal Processor (DSP) (refer to Fig. 5) and the storing/holding of a DC component included in a demodulation signal of the demodulator 30; and a differential amplifier 24 for differentially amplifying and outputting the signal by adding the stored/held DC component to an inversion input terminal and the amplitude-modulated reception signal component to a non-inversion input terminal, as shown in Fig. 4.

Fig. 5 is a block diagram showing an outline configuration of a wireless apparatus according to a preferred embodiment of the present invention using the same carrier frequency for transmission and reception. The wireless apparatus according to a preferred embodiment of the present invention using the same carrier frequency for transmission and reception shown in Fig. 5 is configured the same as the outline configuration of the above-described RFID tag reader/writer, and therefore the description here exemplifies an RFID tag reader/writer. Referring to Fig. 5, the RFID tag reader/writer carries out data reading and writing by transmitting a command (i.e., a transmission command) toward an RFID tag (not shown in any drawing herein) under the management of a Digital Signal Processor (DSP) 1. That is, when a read/write command instruction is issued from the DSP 1 to an RFID tag, a digital/analog (D/A) converter 2 applies, to a mixer 12 of a transmission circuit 10, a read/write command destined to the RFID tag as a baseband (IF) signal. The mixer 12 of the transmission circuit 10 converts the applied baseband (IF) signal into a radio frequency (RF) signal on the basis of the local (Lo) signal 4 and also amplifies the signal by an amplifier 11, then emits the radio frequency (RF) signal toward an RFID tag (not shown in any drawing herein) from an antenna 6 by way of a directional coupler 5. Having received the read/write command from the DSP 1 at a reception unit (not shown in any drawing herein), the RFID tag (not shown in any drawing herein) processes the read/write command within the present RFID tag and also transmits a response signal from the RFID tag toward the DSP 1 from a transmission unit (not shown in any drawing herein). Since a passive type RFID tag does not have a power source for transmitting a signal within the apparatus itself, a transmission signal from the transmission circuit 10 of the RFID tag reader/writer is used for a transmission carrier of the response signal, and the response signal is amplitude-modulated and transmitted toward a reception circuit 20 of the RFID tag reader/writer as a radio frequency (RF) response signal. The amplitude-modulated radio frequency (RF) response signal is first amplified by an amplifier 21 via the antenna 6 and directional coupler 5, then the reception circuit 20 to which a local (Lo) signal is applied converts it into a baseband (IF) signal, and the function of the reception circuit described in Fig. 4, removes the DC component and further amplifies, and then amplified amplitude-modulated baseband (IF) signal is converted a digital response signal by the analog/digital (A/D) converter 3, and the digital response signal is extracted an original signal at the DSP 1, thus resulting in the production of a response signal. In the reception circuit shown in Fig. 5, the function is the same as that of the reception circuit shown in Fig. 4, although the demodulator 30 of the reception circuit shown in Fig. 4 is shown with a detailed circuit comprisal.

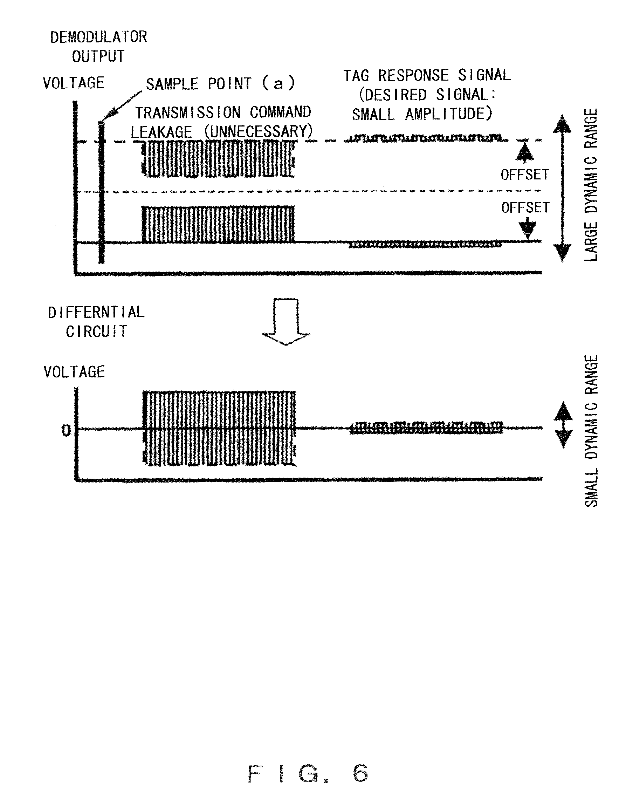

Fig. 6 is a diagram showing an outline of a waveform of the reception circuit shown in Fig. 4 and of the process. The upper part of Fig. 6 shows an output waveform of the demodulator 30, and also shows, as sample point (a), a position for performing sampling. In the waveform diagram in the upper part of Fig. 6, a waveform shown as a solid line and a waveform shown as a dotted line are shown with a DC offset. This indicates the fact that both the solid line waveform and the dotted line waveform are observed as an output of the demodulator DEM in accordance with the distance between the RFID tag reader/writer and the RFID tag, the environment surrounding them, and the carrier leakage from a directional coupler. The sample-hold circuit according to the present invention, however, is contrived to store/hold the DC offset via, for example, sampling at the sample point (a) and applying the held DC offset and the desired signal component to the inversion input terminal and non-inversion input terminal, respectively, of the differential amplifier, thereby making it possible to remove the DC offset completely. Therefore, this configuration enables the extraction of the desired signal component as a result of removal of the DC component as shown in the waveform, diagram shown in the lower portion of Fig. 6 and also enables the acquisition of a desired signal component at a sufficient signal level by performing a high-gain amplification operation for the desired signal component because the desired signal component has a small dynamic range. Note that leakage of the transmission command obtained from the reception circuit is not a desired signal and it is accordingly ignored at the DSP 1.

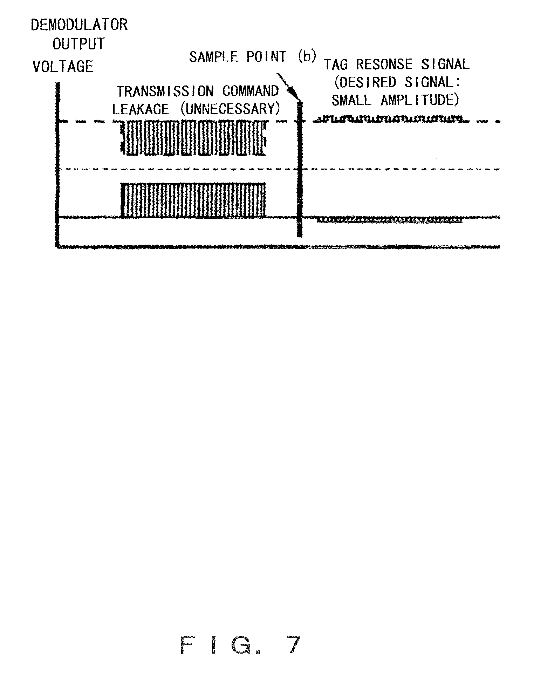

Fig. 7 is a waveform diagram of a different sample point to that shown in the waveform diagram of the upper part of Fig. 6. In Fig.7, the position for performing the sampling to be at sample point (b) is different from the position for performing the sampling to be at sample point (a) in Fig. 6. A different sample point is implemented by issuing a trigger, at a discretionary timing that is not the period of transmitting a transmission command, to the sample-hold circuit 23 from the DSP 1 in association with issuing a read/write instruction from the DSP 1 shown in Fig. 5. The sample-hold circuit according to the present invention is contrived to store/hold a DC offset by sampling at the sample point (b) and to apply the held DC offset and a desired signal component to the inversion input terminal and non-inversion terminal, respectively, of the differential amplifier, thereby making it possible to remove the DC offset completely. As described above, the present invention is enabled to change a sample point position at a discretionary timing between the start of transmitting a read/write command overlapped on a transmission carrier from the transmission circuit 10 of the RFID tag reader/writer following the DSP 1 issuing a read/write command toward an RFID tag and the start of the reception circuit 20 of the RFID tag reader/writer receiving the desired signal component from the RFID tag and also during a period of not transmitting a transmission read/write command. Specifically, it is possible to change the position for performing the sampling of a waveform shown in the upper part of Fig. 6, that is, the position for performing the sampling shown in Fig. 7 (except during the period of transmitting a transmission command) from the sample point (a) to the sample point (b). Note that, alternatively, a plurality of sample-holds may be carried out by transmitting a trigger for a plurality of times from DSP 1 to the sample-hold circuit 23 between the sample point (a) and sample point (b), with the exception during the period of transmitting the transmission command. Yet another configuration may be configured in such a manner so as to change the timing for a sample-hold on the basis of the content of the transmission command; that is, on the basis of whether the transmission command is a read or write command.

As described above, the wireless apparatus according to the present invention using the same carrier frequency for transmission and reception is contrived to have a sample-hold circuit store/hold a DC component generated by an interference wave such as a carrier leakage and to have a differential amplifier at the next stage remove the DC component and amplify the baseband signal, thereby drastically improving the degree of amplification (i.e., the gain) of an amplifier (i.e., an amplification on the order of at least a two-digit multiplication via the application of the present invention, whereas the degree is a multiplication on the order of one digit in the case of the conventional technique) and enabling a secure reproduction of the desired signal component. As a result, the handling of a minute signal from a passive type RFID tag existing far from the antenna becomes easy.

### Industrial Applicability

The wireless apparatus according to the present invention, using the same carrier frequency for transmission and reception, is contrived to enable a secure reproduction of an amplitude-modulated desired signal by completely removing a DC offset of the wireless apparatus and therefore the usage of a passive type RFID tag can be expanded by applying the wireless apparatus according to the present invention to an RFID tag reader/writer utilizing, for example, the passive type RFID tag.

## Claims

1. A wireless apparatus using the same carrier wave for transmission and reception, comprising a demodulator, a sample-hold circuit and a differential amplification circuit, wherein
the sample-hold circuit sample-holds a direct current (DC) component of a demodulation signal obtained from the demodulator, and the differential amplification circuit removes the DC component held by the sample-hold circuit and amplifies/outputs a desired signal component from the demodulator.

2. The wireless apparatus using the same carrier wave for transmission and reception according to claim 1, comprising
a control unit for controlling transmission and reception, wherein
the control unit gives a sample-hold instruction to said sample-hold circuit at a discretionary timing.

3. The wireless apparatus using the same carrier wave for transmission and reception according to claim 2, wherein
said control unit gives said sample-hold instruction between the start of transmitting a command and the start of receiving the desired signal component and also during a period in which the command is not transmitted.

4. The wireless apparatus using the same carrier wave for transmission and reception according to claim 3, wherein
said control unit gives said sample-hold instruction a plurality of times during said period.

5. The wireless apparatus using the same carrier wave for transmission and reception according to claim 3, wherein
said control unit changes the timing for sample-holding in accordance with the content of said command.
